# EUROPEAN PATENT APPLICATION

(11) **EP 3 107 360 A1**
(43) Date of publication of application: **21.12.2016**
(21) Application number: 16173334.0
(22) Date of filing: 07.06.2016
(51) Int. Cl.: H05K 7/14, H05K 5/02

(54) **DEVICE FOR CONVERTING A MODULE OF A STATION FOR CONTROL OF INDUSTRIAL ROBOTS INTO AN INDEPENDENT CONTROL UNIT**

(30) Priority: 15.06.2015 IT UB20151382
(71) Applicant: Comau S.p.A., 10095 Grugliasco (Torino) (IT)
(72) Inventor: BORDEGNONI, Stefano, I-10095 Grugliasco (Torino) (IT); CINIELLO, Francesco, I-10095 Grugliasco (Torino) (IT)
(74) Representative: Frontoni, Stefano

(57) **Abstract**

A device for converting a module of a station for control of industrial robots into an independent control unit. The device comprises a frame (2) configured for housing said module (100), which has a supporting part (22), designed to support the entire frame and to rest on a resting surface, a part (26), designed to receive said control module, and a covering part (32), which encloses cables for electrical connection of said module and is configured for guiding passage of said cables towards the outside of said device.

## Description

The present invention relates to a device for converting a module of a station for control of industrial robots into an independent control unit.

Known to the art are stations for control of industrial robots that are characterized in that they comprise a plurality of control modules usually arranged all together within cabinets located in marginal regions of the production area in which the robots operate.

The object of the present invention is to enable use of the individual control modules as stand-alone and autonomous control units.

The object indicated above is achieved via a conversion device that presents the characteristics recalled in the ensuing claims.

Thanks to the device described herein, the various modules of a robot-control station that are located in the area of production of an industrial plant can hence be temporarily or permanently removed from the station and form stand-alone control units, temporarily or permanently assigned to other types of uses. For example, the individual modules may be transferred into the laboratory and be used for programming and testing prototypes of robots at a reduced scale, or else may be used in the office environment for analysis and programming purposes, or else may be again used within the industrial plant but for applications in which they operate as autonomous control units.

The possibility of adapting control modules of the type in question specifically for uses where, also from the structural standpoint, they have the role of altogether autonomous units, has not in fact so far been made available.

The claims form an integral part of the technical teaching provided herein in relation to the invention.

The invention will now be described purely by way of non-limiting example, with reference to the annexed representations, wherein:

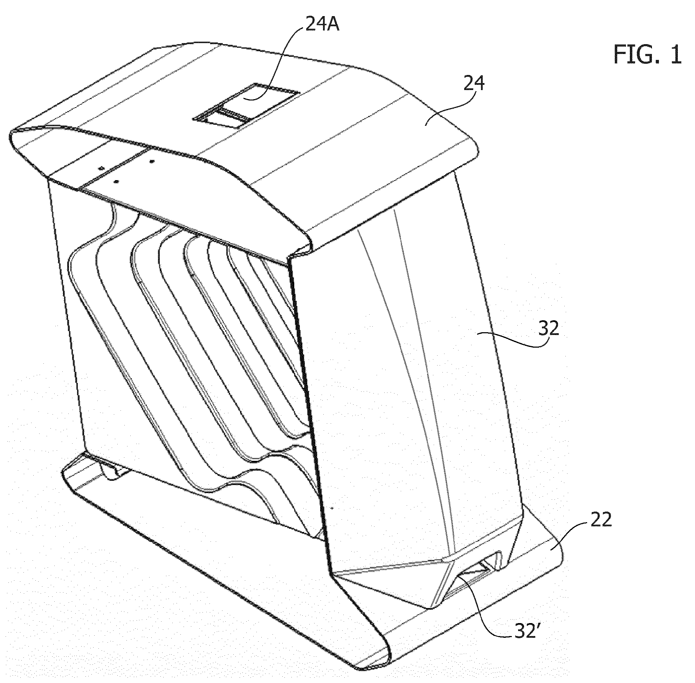

- Figure 1 represents a first embodiment of the device described herein, according to a perspective view;
- Figure 2 represents an example of use of the device of Figure 1; and

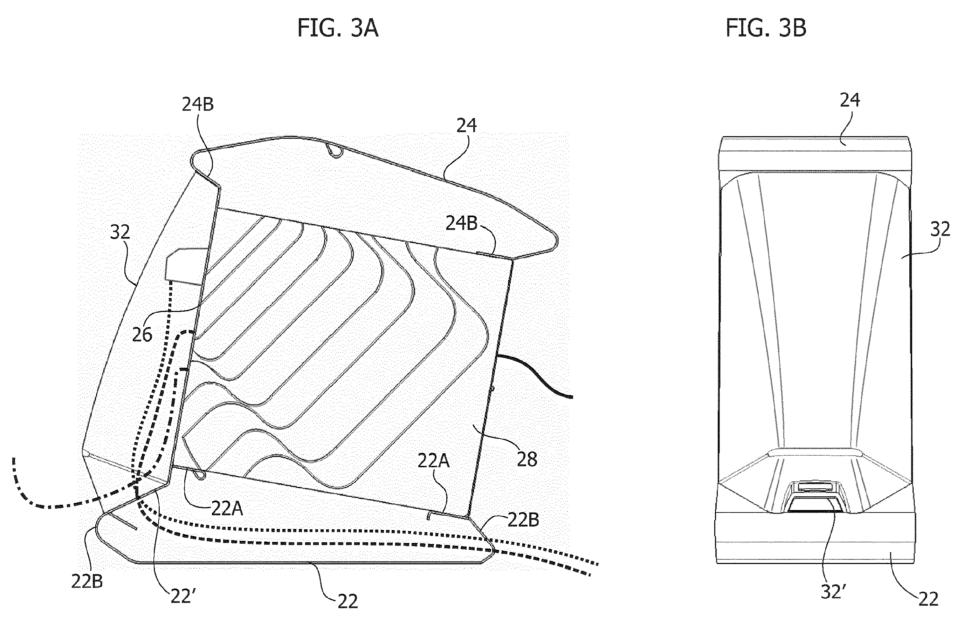

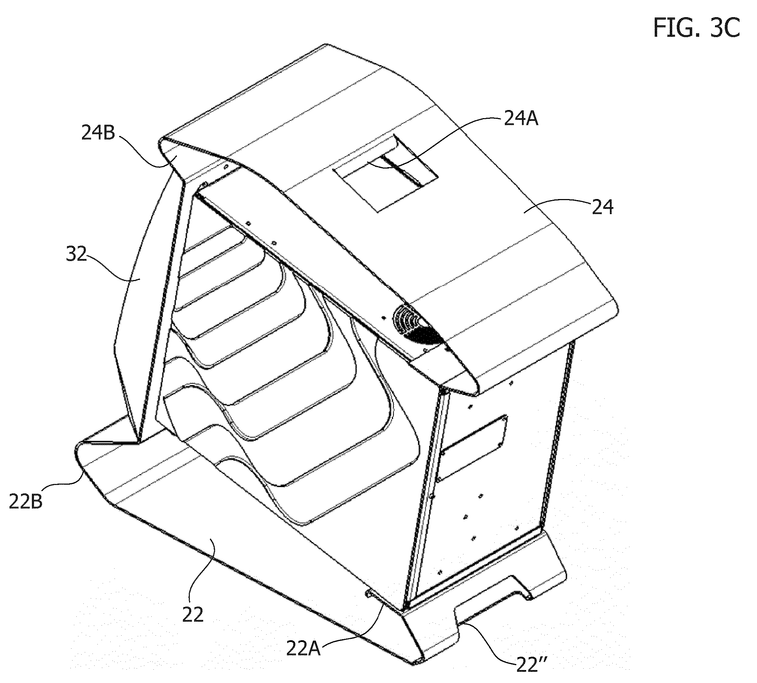

- Figures 3a, 3b, and 3c represent the device of Figure 1 according to further views, respectively a side view, a front view, and a perspective view from the back.

In the ensuing description, various specific details are illustrated aimed at providing an in-depth understanding of the embodiments. The embodiments may be obtained without one or more of the specific details, or with other methods, components, or materials, etc. In other cases, known structures, materials, or operations are not shown or described in detail so that the various aspects of the embodiment will not be obscured.

The references used herein are only for convenience and hence do not define the sphere of protection or the scope of the embodiments.

With reference to the figures, they represent an embodiment of the device described, designated as a whole herein by the reference number 10.

As mentioned above, in general the device described herein has the function of converting a module of a station for control of industrial robots into an independent control unit, which by itself may be assigned to new applications or uses.

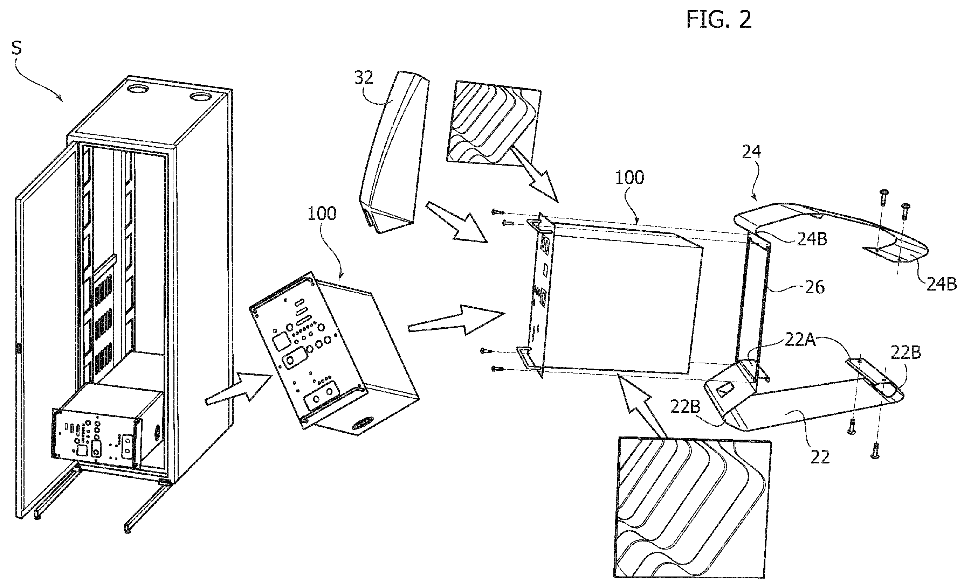

Figure 2 represents an example of control station S, constituted by a cabinet, the internal walls of which are provided with a vertical series of rails extractably mounted on which, one on top of the other, is a plurality of control modules 100.

The device 10 comprises a frame 2, which is configured for housing inside it a single module 100, and which at the same time defines passage for the electrical cables for connection of the module to the power mains and to the various apparatuses with which, according to the applications, the module interfaces. In various preferred embodiments, the frame 2 is configured for housing the module 100 according to an orientation in which, with respect to the normal condition in which the module is mounted within the control station, it is rotated through 90° about an ideal axis transverse to its front side; in particular, the front side of the module is set with its longitudinal edges oriented transverse to the horizontal plane.

In various embodiments, as in the one illustrated, the frame 2 comprises a bottom part 22, which is configured for supporting the entire frame and is designed to rest on a resting surface, a top part 24, and a central part 26, which connects the parts 22 and 24 and is configured for housing the module 100.

In various preferred embodiments, as in the one illustrated, the bottom part 24 identifies two portions 24a on which the bottom side of the module 100 directly rests, which are configured so as to orient the module according to a position inclined upwards, rendering more accessible its front side on which the various ports or connectors for connection of the cables are provided.

In various embodiments, as in the one illustrated, the frame 2 further comprises a front covering body 32, which is removably mounted on the parts 22, 24 and 26 and covers the cables connected to the front side of the module.

Moreover, the covering body 32 and the bottom part 22 define appropriate passages for the cables. In various preferred embodiments, as in the one illustrated, the body 32 then presents a bottom opening 32' so as to enable exit of the cables from the front side of the frame, and the bottom part 22 has, instead, a first front opening 22', through which the cables enclosed by the body 32 can pass within the bottom part 22, and a second rear opening 22", through which the above cables can exit from the frame at the back. When the cables are to be connected to or removed from the front side of the module, it is sufficient to remove the lid 32. The particular inclined position that is assumed by the module mounted on the frame 2 facilitates insertion of the cables in the respective ports or connectors provided on the front side.

In various embodiments, as in the one illustrated, the top part 24 has a portion 24A appropriately configured for constituting a grip or handle via which the frame 2 can be gripped by an operator with his hand and conveniently carried.

In various particularly preferred embodiments, as in the one illustrated, the frame 2 described above comprises a single piece of sheet metal appropriately cut and bent so as to define by itself the aforesaid bottom and top parts 22, 24, and the central part 26 that connects them together. The latter is constituted by a frame structure set at the front, the module 100 being received in the opening. The parts 22 and 24 constitute, instead, two opposed parts of the piece of bent sheet metal, which are transverse with respect to the central part 26 and have portions 22b, 24b curved towards the inside of the frame in the respective end regions. The front curved portions of the two parts 22 and 24 are directly connected together by the central part 26. The two curved portions 22b of the part 22 moreover have distal flaps that define the portions 22a mentioned above on which the module 100 directly rests. The rear curved portion 24b of the part 24 is also configured for engaging directly the module 100 at the top side thereof. Consequently, in the rear region of the frame, both of the two curved portions 22b, 24b are designed to engage simultaneously the structure of the module 100, and this, when it is mounted on the frame 2, rigidly connects the above portions together. Preferably, the portions may be fixed, respectively, to the bottom and top sides of the module via screws. Likewise, the frame structure 26 may be fixed via screws to the front side of the module.

It should be noted how, in the configuration described above, the module 100 comes to form part of the load-bearing structure of the device, so that the device can advantageously present a very simple and essential structure, this enabling a considerable saving of material and a significant reduction of the respective production costs.

In various preferred embodiments, as in the one illustrated, the device further comprises two panels 28, preferably made of plastic material, which are directly fixed on the two opposite sides of the module 100, preferably using adhesive material. These panels basically have an aesthetic function, and, thanks to the type of material of which they are made, can be easily obtained according to a wide range of styles and conformations.

Figure 2 illustrates the modality with which the module 100 belonging to the control station illustrated in the figure can be mounted on the frame of the device described herein and, in this way, reconverted into an autonomous control unit.

The new control unit thus formed presents, on the one hand, the series of functional and ergonomic characteristics discussed above and, at the same time, also an altogether appreciable aesthetic appearance, an aspect that is certainly not negligible above all if the unit is designed for environments other than proper industrial plants.

Of course, without prejudice to the principle of the invention, the details of construction and the embodiments may vary, even significantly, with respect to what is illustrated herein purely by way of non-limiting example, without thereby departing from the scope of the invention, as defined by the annexed claims.

## Claims

1. A device for converting a module of a station for control of industrial robots into an independent control unit, said device comprising a frame (2) configured for housing said module (100), which has a supporting part (22), designed to rest on a resting surface and to support the entire frame, a part (26), designed to receive said control module, and a covering part (32), which encloses cables for electrical connection of said module and is configured for guiding passage of said cables towards the outside of said device.

2. The device according to Claim 1, wherein said supporting part (22) is configured for orienting, according to a position inclined upwards, one side of said module on which ports and/or connectors for electrical connection of said module are set, and wherein said covering part (32) is configured for covering said side of said module.

3. The device according to Claim 2, wherein said supporting part (22) defines inside it a passage for the cables, which are connected to said side of said module and are enclosed by said covering part (24), towards the outside of said device, through a side of the device opposite to the one where said covering part (32) is located.

4. The device according to Claim 2 or Claim 3, wherein said covering part (32) has an opening (32') for exit of the cables on the outside of the device, on the same side where said covering part (32) is located.

5. The device according to any one of the preceding claims, wherein said frame comprises a bottom part (22) corresponding to said supporting part, a top part (24), and a front part (26) for connection of said top and bottom parts, which corresponds to said part for receiving said module, wherein said top and bottom parts (22, 24) each have, in respective opposite regions with respect to said front part, an engagement portion (22a, 24b) of said module, in such a way that, in the condition where said module is mounted on said device, it rigidly connects said top and bottom parts together.

6. The device according to Claim 5, wherein said frame comprises a structure made of sheet metal appropriately cut and bent so as to define said bottom and top parts (22, 24) and said receiving part (26).

7. The device according to any one of the preceding claims, wherein said receiving part has a frame structure, in the central opening of which said module is received.

8. The device according to any one of the preceding claims, wherein said covering part (32) is mounted in a removable way.
